# EUROPÄISCHE PATENTSCHRIFT

(11) **EP 3 631 888 B1**
(45) Veröffentlichungstag und Bekanntmachung des Hinweises auf die Patenterteilung: **27.07.2022**
(21) Anmeldenummer: 18730252.6
(22) Anmeldetag: 24.05.2018
(51) Int. Cl.: H01M 10/48, G01R 31/36

(54) **VERFAHREN UND VORRICHTUNG ZUM BESTIMMEN EINER BETRIEBSTEMPERATUR, BETRIEBSVERFAHREN FÜR EINE BATTERIEZELLE, STEUEREINHEIT FÜR EINE BATTERIEZELLE UND ARBEITSVORRICHTUNG**
METHOD AND DEVICE FOR DETERMINING AN OPERATING TEMPERATURE, OPERATING METHOD FOR A BATTERY CELL, CONTROL UNIT FOR A BATTERY CELL, AND WORKING DEVICE
PROCÉDÉ ET DISPOSITIF SERVANT À DÉFINIR UNE TEMPÉRATURE DE FONCTIONNEMENT, PROCÉDÉ DE FONCTIONNEMENT POUR UN ÉLÉMENT DE BATTERIE, UNITÉ DE COMMANDE POUR UN ÉLÉMENT DE BATTERIE ET DISPOSITIF DE TRAVAIL

(30) Priorität: 31.05.2017 DE 102017209182
(43) Veröffentlichungstag der Anmeldung: 08.04.2020
(73) Patentinhaber: Bayerische Motoren Werke Aktiengesellschaft, 80809 München (DE)
(72) Erfinder: SCHMIDT, Jan Philipp, 80997 München (DE); MÜLLER, Jennifer, 80636 München (DE); ZEHENTNER, Hermann, 84432 Hohenpolding (DE)
(86) Internationale Anmeldenummer: PCT/EP2018/063585
(87) Internationale Veröffentlichungsnummer: WO 2018/219761

(56) Entgegenhaltungen:
- WO-A1-2006/048625
- US-A1- 2017 085 107

## Beschreibung

Die vorliegende Erfindung betrifft ein Verfahren und eine Vorrichtung zum Bestimmen einer Betriebstemperatur einer Batteriezelle, ein Betriebsverfahren für eine Batteriezelle, eine Steuereinheit für eine Batteriezelle und eine Arbeitsvorrichtung, insbesondere ein Fahrzeug.

Beim Betrieb elektrischer Anlagen auf der Grundlage von Batteriezellen, also beim Einsatz von Batterien und Batteriezellmodulen, ist die Betriebstemperatur einer jeweiligen Batteriezelle ein für den Betrieb wesentlicher Parameter, auch im Hinblick auf Aspekte der Effizienz und der Betriebssicherheit.

Eine jeweilige Betriebstemperatur innerhalb einer Batteriezelle kann mit Aufwand direkt gemessen werden. Zur Verminderung des Aufwands werden jedoch indirekte Messverfahren eingesetzt, zum einen über die Verwendung in Bezug auf eine jeweilige Batteriezelle externer Sensoren und/oder über das Messen der Impedanz einer jeweiligen Batteriezelle.

Der Rückgriff auf die Impedanz einer Batteriezelle ist jedoch mit einem Energieverlust verbunden. Andererseits kann auf eine impedanzbasierte Temperaturbestimmung wegen ihrer hohen Zuverlässigkeit nicht verzichtet werden.

Der Erfindung liegt die Aufgabe zu Grunde, ein Verfahren und eine Vorrichtung zum Bestimmen einer Betriebstemperatur einer Batteriezelle, ein Betriebsverfahren für eine Batteriezelle, eine Steuereinheit für eine Batteriezelle sowie eine Arbeitsvorrichtung und insbesondere ein Fahrzeug anzugeben, bei welchen die Betriebstemperatur einer Batteriezelle als Betriebsparameter mit hoher Zuverlässigkeit und mit möglichst geringem Energieverlust bestimmt werden kann.

Die der Erfindung zu Grunde liegende Aufgabe wird mit den Merkmalen der unabhängigen Patentansprüche gelöst. Vorteilhafte Weiterbildungen sind jeweils Gegenstand der abhängigen Ansprüche.

Gemäß einem ersten Aspekt der vorliegenden Erfindung wird ein Verfahren zum Bestimmen einer Betriebstemperatur einer Batteriezelle, insbesondere bei einer elektrisch betreibbaren Arbeitsvorrichtung oder einem Fahrzeug, geschaffen, bei welchem (i) eine externe Temperatur der Batteriezelle (10) - insbesondere kontinuierlich Oderabschnittsweise kontinuierlich mit einem auBerhalb der Batteriezelle (10) angeordneten Sensor (20) erfasst wird, (ii) eine interne Temperatur der Batteriezelle über ein Erfassen einer elektrischen Impedanz der Batteriezelle bestimmt wird und (iii) aus der externen und/oder der internen Temperatur ein Wert der Betriebstemperatur der Batteriezelle bestimmt wird. Erfindungsgemäß wird (A) die interne Temperatur der Batteriezelle zumindest in einem ersten Betriebszustand der Batteriezelle weniger häufig bestimmt, wenn der Wert der ermittelten externen Temperatur, der internen und/oder der Betriebstemperatur der Batteriezelle in einem vorgegebenen ersten sicheren Bereich liegt. Sie wird (B) im Vergleich dazu häufiger bestimmt, wenn der Wert der ermittelten externen Temperatur, der internen Temperatur und/oder der Betriebstemperatur der Batteriezelle außerhalb des vorgegebenen ersten sicheren Bereichs liegt.

Gemäß der vorliegenden Erfindung kann eine der bestimmten Temperaturen, nämlich die interne Temperatur der Batteriezelle, die externe Temperatur der Batteriezelle oder eine daraus abgeleitete Betriebstemperatur der Batteriezelle in Beziehung gesetzt werden zu dem vorgegebenen ersten sicheren Bereich.

Denkbar ist auch ein Inbeziehungsetzen einer Kombination dieser Temperaturen. Bei einem vorgegebenen ersten sicheren Bereich kann es sich um ein geschlossenes, offenes oder halboffenes Werteintervall, um eine Menge von diskreten Werten oder deren beliebige Kombination handeln.

Das Maß der Häufigkeit für die Bestimmung der internen Temperatur der Batteriezelle kann unterschiedlich ausgestaltet und an die jeweiligen Bedingungen der Batteriezelle und/oder einer von der Batteriezelle versorgten Vorrichtung angepasst sein oder werden.

So ist es bei einer bevorzugten Ausgestaltungsform des erfindungsgemäßen Verfahrens vorgesehen, dass die interne Temperatur der Batteriezelle weniger häufig bestimmt wird als die externe Temperatur der Batteriezelle, wenn der Wert der ermittelten externen Temperatur, der internen Temperatur und/oder der Betriebstemperatur der Batteriezelle innerhalb des vorgegebenen ersten sicheren Bereichs liegt.

Bei einer vorteilhaften Weiterbildung des erfindungsgemäßen Verfahrens ist es insbesondere vorgesehen, dass die interne Temperatur der Batteriezelle nicht oder nicht weiter bestimmt wird, wenn der Wert der ermittelten externen Temperatur, der internen Temperatur und/oder der Betriebstemperatur der Batteriezelle innerhalb des vorgegebenen ersten sicheren Bereichs liegt. Gemäß dieser Maßnahme wird davon ausgegangen, dass hinsichtlich der Temperatur für eine Batteriezelle kein kritischer Zustand vorliegt, wenn eine jeweils in Bezug gesetzte Temperatur, also die interne Temperatur, die externe Temperatur und/oder die abgeleitete Betriebstemperatur, innerhalb des vorgegebenen ersten sicheren Bereichs liegt bzw. liegen.

Das zellexterne Erfassen eines Werts einer Messgröße kann auf verschiedene Weisen realisiert werden. Bei einer besonders einfachen Ausgestaltung der vorliegenden Erfindung wird das zur Batteriezelle zellexterne Erfassen des Werts der Messgröße über mindestens einen in Bezug auf die Batteriezelle zellnahen und/oder zellexternen Sensor durchgeführt, insbesondere unter Verwendung eines Temperatursensors. Dabei ergeben sich besonders zuverlässige Messergebnisse dann, wenn der zellexterne Sensor zum Beispiel an einer Außenwand und/oder an einem Gehäuse der zu Grunde liegenden Batteriezelle angebracht ist oder mit dieser in mechanischem und/oder thermischem Kontakt steht, vorzugsweise an einem oder im Bereich eines Zellanschlusses oder Zellterminals oder als Teil davon.

Werden Werte der externen Temperatur der Batteriezelle ohne Weiteres zu Grunde gelegt, um das Verhalten und den Betrieb einer Batteriezelle zu steuern, können sich Fehleinschätzungen ergeben. In der Regel müssen extern erfasste Werte einer Korrektur unterzogen werden. Da ist es besonders vorteilhaft, wenn gemäß einer anderen bevorzugten Ausgestaltungsform des erfindungsgemäßen Verfahrens zum Bestimmen der externen Temperatur der Batteriezelle der erfasste Wert der Messgröße in einem Temperaturmodell für die Batteriezelle verwendet wird. Dieses Temperaturmodell ist in vorteilhafter Weise dazu eingerichtet, sämtliche Korrekturmechanismen, zu Beispiel Offsets und/oder zeitliche Verzögerungen, zu berücksichtigen.

Da im Allgemeinen interne Temperaturen der Batteriezelle einen höheren Grad der Verlässlichkeit besitzen, und zwar verglichen mit Werten auf der Grundlage von Werten der externen Temperatur der Batteriezelle, können gemäß einer anderen Weiterbildung des erfindungsgemäßen Verfahrens zur Anpassung und/oder Stützung des Temperaturmodells gegebenenfalls ein oder mehrere über die elektrische Impedanz der Batteriezelle erfasste Werte der internen Temperatur der Batteriezelle verwendet werden.

Der jeweils in Rede stehende erste Betriebszustand der Batteriezelle kann ein Ruhezustand der Batteriezelle, ein Lastzustand der Batteriezelle oder ein Entladezustand der Batteriezelle sein, bei welchem der Batteriezelle Energie entnommen wird oder die Batteriezelle Energie abgibt.

Alternativ oder zusätzlich dazu kann in einem zweiten Betriebszustand der Batteriezelle, welcher vom ersten Betriebszustand der Batteriezelle verschieden ist und welcher insbesondere einem Ladezustand der Batteriezelle oder einem Rekuperationszustand der Batteriezelle entspricht, bei welchem der Batteriezelle Energie zugeführt wird oder die Batteriezelle Energie aufnimmt, die Häufigkeit des Bestimmens der internen Temperatur der Batteriezelle unabhängig sein von der Lage der ermittelten externen Temperatur, der internen Temperatur und/oder der Betriebstemperatur der Batteriezelle in Bezug auf den vorgegebenen ersten sicheren Bereich und kann insbesondere der Häufigkeit des Bestimmens der externen Temperatur der Batteriezelle entsprechen.

Gemäß einem weiteren Aspekt der vorliegenden Erfindung wird auch ein Betriebsverfahren für eine Batteriezelle geschaffen, insbesondere bei einer elektrisch betreibbaren Arbeitsvorrichtung oder bei einem Fahrzeug, wobei eine Betriebstemperatur der Batteriezelle durch ein erfindungsgemäßes Verfahren zum Bestimmen einer Betriebstemperatur einer Batteriezelle bestimmt und zur Steuerung des Betriebs der Batteriezelle verwendet wird.

Bei einer vorteilhaften Weiterbildung des erfindungsgemäßen Betriebsverfahrens wird geprüft, ob der Wert der externen Temperatur der Batteriezelle, der Wert der internen Temperatur der Batteriezelle und/oder der Wert der abgeleiteten Betriebstemperatur der Batteriezelle außerhalb eines zweiten vorgegebenen kritischen Bereichs liegt bzw. liegen, welcher den vorgegebenen ersten Bereich - aufgefasst als erster sicherer Bereich - umfasst.

Erfindungsgemäß wird dabei in Abhängigkeit von einem Ergebnis dieses Prüfens ein Betriebszustand der Batteriezelle gewählt und/oder beeinflusst.

Ferner wird durch die vorliegende Erfindung auch eine Steuereinheit für eine Batteriezelle und/oder für eine Arbeitsvorrichtung oder ein Fahrzeug mit einer Batteriezelle geschaffen, welche eingerichtet ist, ein erfindungsgemäßes Verfahren zum Bestimmen einer Betriebstemperatur einer Batteriezelle und/oder erfindungsgemäßes ein Betriebsverfahren für eine Batteriezelle auszuführen.

Des Weiteren ist Gegenstand der vorliegenden Erfindung auch eine Vorrichtung zum Bestimmen einer Betriebstemperatur einer Batteriezelle, insbesondere bei einer elektrisch betreibbaren Arbeitsvorrichtung oder einem Fahrzeug.

Die erfindungsgemäße Vorrichtung ist ausgebildet mit einer Impedanzmesseinrichtung, welche zur Messung einer elektrischen Impedanz der Batteriezelle eingerichtet ist, mit einer Temperaturmesseinrichtung, welche zur Messung einer externen Temperatur der Batteriezelle oder eines dafür repräsentativen Messwerts eingerichtet ist und dazu insbesondere einen in Bezug auf die Batteriezelle zellennahen und/oder zellexternen Sensor oder eine Wirkverbindung zu einem in Bezug auf die Batteriezelle zellennahen und/oder zellexternen Sensor aufweist.

Des Weiteren ist eine erfindungsgemäß ausgestaltete Steuereinheit ausgebildet, welche zur Erfassung von Messwerten der Impedanzmesseinrichtung und der Temperaturmesseinrichtung eingerichtet ist.

Schließlich sind auch eine Arbeitsvorrichtung und insbesondere ein Fahrzeug Gegenstand der vorliegenden Erfindung, wobei diese ausgebildet sind mit einem elektrisch antreibbaren Aggregat und insbesondere mit einem Antrieb, mit einer Batteriezelle zur steuerbaren Versorgung des Aggregats mit elektrischer Energie und mit einer Steuervorrichtung zur Steuerung des Betriebs des Aggregats und/oder der Batteriezelle, welche ausgebildet ist mit einer erfindungsgemäß ausgestalteten Steuereinheit und/oder mit einer erfindungsgemäß ausgestalteten Vorrichtung und/oder dazu, ein erfindungsgemäßes Verfahren zum Bestimmen einer Betriebstemperatur einer Batteriezelle und/oder ein erfindungsgemäßes Betriebsverfahren für eine Batteriezelle auszuführen.

### Kurzbeschreibung der Figuren

Weitere Einzelheiten, Merkmale und Vorteile der Erfindung ergeben sich aus der nachfolgenden Beschreibung und den Figuren.
- Figur 1: zeigt ein schematisches Blockdiagramm einer erfindungsgemäßen Vorrichtung zum Bestimmen einer Betriebstemperatur einer Batteriezelle.
- Figuren 2 und 3: zeigen Graphen, welche Ausführungsformen des erfindungsgemäßen Verfahrens zum Bestimmen einer Betriebstemperatur einer Batteriezelle erläutern.

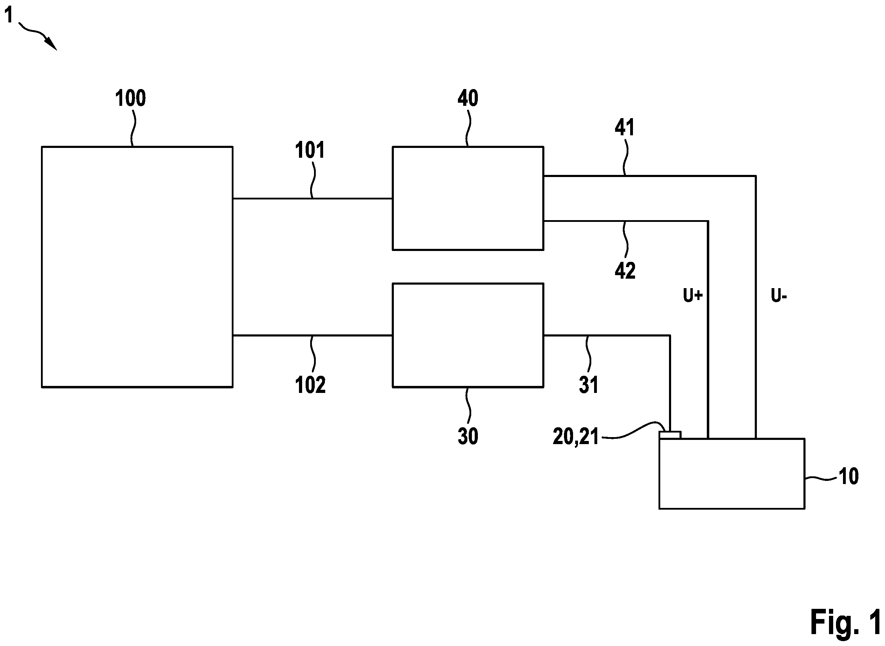

Nachfolgend werden unter Bezugnahme auf die Figuren 1 bis 3 Ausführungsbeispiele und der technische Hintergrund der Erfindung im Detail beschrieben. Gleiche und äquivalente sowie gleich oder äquivalent wirkende Elemente und Komponenten werden mit denselben Bezugszeichen bezeichnet. Nicht in jedem Fall ihres Auftretens wird die Detailbeschreibung der bezeichneten Elemente und Komponenten wiedergegeben.

Die dargestellten Merkmale und weiteren Eigenschaften können in beliebiger Form voneinander isoliert und beliebig miteinander kombiniert werden, ohne den Kern der Erfindung zu verlassen.

Figur 1 zeigt ein schematisches Blockdiagramm einer erfindungsgemäßen Vorrichtung 1 zum Bestimmen einer Betriebstemperatur einer Batteriezelle 10.

Die erfindungsgemäße Vorrichtung 1 gemäß Figur 1 weist eine Impedanzmesseinrichtung 40 und eine Temperaturmesseinrichtung 30 auf.

Die Temperaturmesseinrichtung 30 ist über eine Erfassungs- und Steuerleitung 31 mit einem Sensor 20, zum Beispiel einem Temperatursensor 21, verbunden, welcher außerhalb und somit extern zur Batteriezelle 10 und zu dieser benachbart angeordnet ist, also nach der Batteriezelle 10, zum Beispiel mit einer Befestigung an deren Außenseite oder an der Außenseite eines Gehäuses der Batteriezelle 10.

Die Impedanzmesseinrichtung 40 ist über erste und zweite Erfassungs- und Steuerleitungen 41 und 42 mit der Batteriezelle 10 verbunden und dazu eingerichtet, eine Gleichstrom- oder eine Wechselstromimpedanz der Batteriezelle 10 zu ermitteln.

Die von der Impedanzmesseinrichtung 40 und der Temperaturmessvorrichtung 30 ermittelten Daten werden über erste und zweite Steuer- und Erfassungsleitungen 101 und 102 einer Steuereinheit für 100 an diese übertragen und von dieser ausgewertet, um zum Beispiel eine externe Temperatur der Batteriezelle 10, eine interne Temperatur der Batteriezelle 10 und/oder eine Betriebstemperatur der Batteriezelle 10 und/oder deren zeitliche Verläufe zu ermitteln.

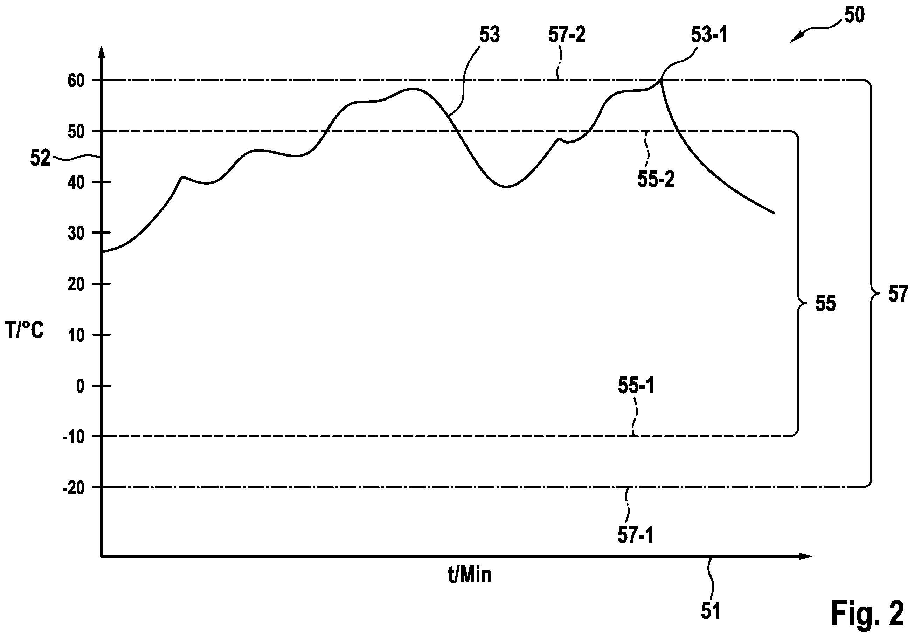

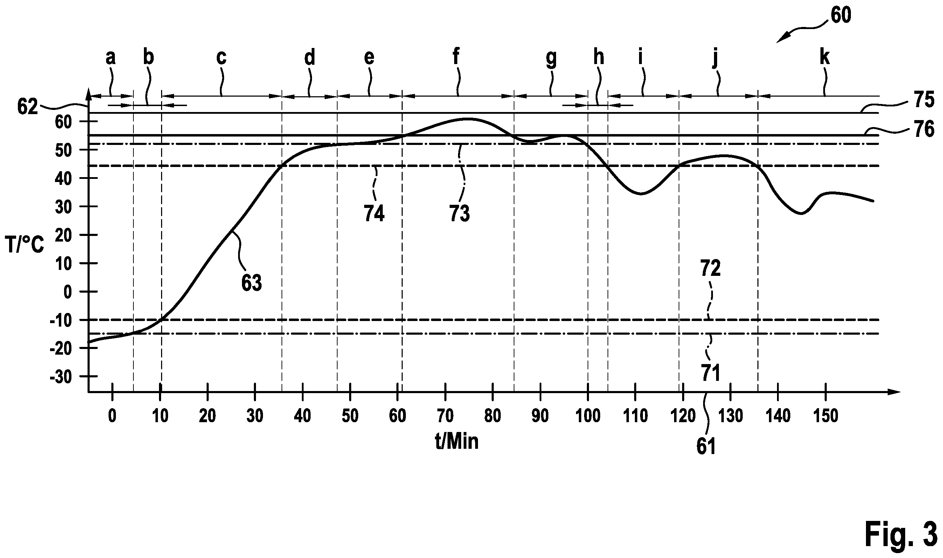

Figuren 2 und 3 zeigen Graphen 50 und 60, welche Ausführungsformen des erfindungsgemäßen Verfahrens zum Bestimmen einer Betriebstemperatur einer Batteriezelle 10 erläutern.

Auf den Abszissen 51 und 61 ist jeweils die Zeit, zum Beispiel in Minuten, aufgetragen, auf den Ordinaten 52 und 62 die Temperatur in Grad Celsius. Die

Spuren 53 und 63 beschreiben jeweils den Verlauf einer Temperatur als Funktion der Zeit, sei dies die interne Temperatur der Batteriezelle 10, die externe Temperatur der Batteriezelle 10 oder eine daraus abgeleitete Betriebstemperatur der Batteriezelle 10.

In Figur 2 ist ein erster vorgegebener sicherer Bereich 55, hier in Form eines Temperaturintervalls zwischen einem unteren Schwellenwert 55-1 als Untergrenze und einem oberen Schwellenwert 55-2 als Obergrenze, dargestellt. Des Weiteren ist ein zweiter kritischer Bereich 57 markiert, welcher den ersten sicheren Bereich 55 voll umfasst und welcher durch einen unteren Schwellenwert 57-1 als Untergrenze und einem oberen Schwellenwert 57-2 als Obergrenze nach Art eines Intervalls begrenzt wird. Liegt der Temperaturverlauf 53 innerhalb des ersten sicheren Bereichs 55, so erfolgt erfindungsgemäß die mit einem höheren Energieverbrauch im Zusammenhang stehende Bestimmung der internen Temperatur der Batteriezelle 10 über die Impedanzmessung weniger häufig, und zwar im Vergleich zu Zeitpunkten, bei welchen der Temperaturverlauf 53 außerhalb der Grenzen 55-1 und 55-2 des ersten sicheren Bereichs 55 liegt. In diesen Fällen erfolgt die Bestimmung der internen Temperatur auf der Grundlage der Impedanzmessung vergleichsweise häufiger. In Fällen, bei denen der Verlauf 53 der Temperatur die Grenzen 57-1 oder 57-2 des zweiten kritischen Bereichs 57 überschreitet oder zu überschreiten droht, zum Beispiel an der mit 53-1 gekennzeichneten Stelle, kann der Betrieb der Batteriezelle 10 in einen sicheren Modus überführt werden. Die Batteriezelle 10 kann zum Beispiel abgeschaltet werden.

Figur 3 zeigt ebenfalls nach Art eines Graphen 60 den Verlauf 63 der Temperatur im Zusammenhang mit einer Batteriezelle 10, zum Beispiel die externe Temperatur, die interne Temperatur oder eine daraus abgeleitete Betriebstemperatur der Batteriezelle 10. Dargestellt sind hier als Schwellen oder Grenzen eine untere Degradationsschwelle 71 für eine aus der Impedanz bestimmte Temperatur, eine untere Degradationsschwelle 72 für die Temperatur, die mittels eines externen Sensors 20, 21 ermittelt wurde, eine obere Degradationsschwelle 73 für die Temperatur aus einer Impedanzmessung, eine obere Degradationsschwelle 74 für eine extern ermittelte Temperatur, eine

Sicherheitsschwelle 75 für eine mittels Impedanzmessung bestimmte Temperatur sowie eine Sicherheitsschwelle 76 für eine extern mittels eines Sensors 20 ermittelte Temperatur. Die ebenfalls im Graphen 60 eingezeichneten Phasen a bis k werden nachfolgend unten im Detail erläutert.

Diese und weitere Merkmale und Eigenschaften der vorliegenden Erfindung werden an Hand der folgenden Darlegungen weiter erläutert:
Die innere Temperatur einer Batteriezelle 10 wird als externer Temperaturwert oft über externe Sensoren 20, 21 ermittelt.
Dabei tritt zwangsläufig eine zeitliche Verzögerung auf und es muss ein gewisser Vorhalt vorgesehen werden, weil zwischen der maßgeblichen Temperatur eines Elektrodenwickels oder -stapels und der externen Messstelle eine Temperaturdifferenz auftreten kann.

Es werden unter solchen Umständen Verfahren angewandt, durch die eine innere Temperatur einer Batteriezelle 10 aus der Impedanz bestimmt wird.

Die Temperaturbestimmung über eine Impedanzmessung ist möglich, hat aber einen erhöhten Energieverbrauch zur Folge.

Wird die Anregungsenergie direkt aus der Batteriezelle 10 entnommen - zum Beispiel mit Anregung über einen Balancingwiderstand - so wird diese ständig entladen. Bei einer aktiven Anregung über einen Inverter treten zumindest dissipative Verluste über den Zellinnenwiderstand auf.

In Abhängigkeit von der Anregungsmethode können auf Grund der Verluste Reichweiteneinbußen im einstelligen Prozentbereich entstehen.

Erfindungsgemäß werden verschiedene Betriebsbereiche bei Betrieb einer Batteriezelle 10 und bei der Temperaturbestimmung vorgesehen:
Befindet sich eine extern ermittelte Temperatur in einem inneren und/oder schmaleren Band oder Wertebereich, so kann von einer Messung der internen Zelltemperatur über die Impedanz abgesehen werden oder diese kann mit einer niedrigen Messrate - von z.B. 0,02Hz - bestimmt werden.

Die aus der Impedanz bestimmte Temperatur wird dann zur Stützung eines Temperaturmodells verwendet.

Verlässt die extern ermittelte Temperatur das innere Band 55 oder den inneren und/oder schmaleren Wertebereich 55, so wird mit einer aus einem Sicherheitskonzept vorgegebenen Frequenz oder Häufigkeit die Zelltemperatur aus der Impedanz bestimmt.

Hierdurch kann die Leistungsfreigabe in diesem Temperaturbereich gewährleistet werden.

Im stationären Betrieb - z.B. an einer Ladesäule - ist eine dauerhafte Bestimmung der Temperatur über die Impedanz immer möglich.

Als Vorteile stellen sich ein geringerer Energieverbrauch und damit eine höhere Reichweite ein, und zwar unverändert bei Aufrechterhaltung der Vorteile einer Temperaturmessung über die Zellimpedanz.

Weitere zusätzliche oder alternative Aspekte der vorliegenden Erfindung ergeben sich auch im Zusammenhang mit den nachfolgenden Erläuterungen:
Durch Impedanzmessung oder abgewandelte Verfahren kann die mittlere innere Zelltemperatur oder Temperatur einer Batteriezelle 10 bestimmt werden.
- Die so erhaltenen Temperaturwerte bilden die tatsächliche innere Temperatur genauer und schneller ab, als durch einen externen Sensor 20, 21 erfasste Temperaturwerte.
- Aus durch externe Sensoren erfassten Temperaturen müssen über Modelle erst die inneren Temperaturen der Zellen prädiziert werden.
- Dadurch müssen Abschaltgrenzen oder Degradationsschwellwerte für Temperaturwerte aus externer Sensorik enger ausgelegt werden als für die ermittelte Temperatur aus der Impedanz (innerer Temperaturwert)
- Durch die Impedanzmessung wird Energie verbraucht.
- Abhängig von der ermittelten Temperatur wird die Messung über einen externen Sensor 20, 21 herangezogen oder alternativ oder zusätzlich die Impedanzmessung durchgeführt.

Die in Figur 3 dargestellten Phasen a bis k haben folgende Bedeutung, wobei TEIS die Temperaturbestimmung aus der Impedanz ermittelt und Text die mit externem Sensor ermittelte Temperatur bezeichnen.
(a) TEIS ist aktiv, Strom muss degradiert werden.
(b) TEIS ist aktiv, Strom nicht mehr degradiert, bei Verwendung von Text müsste degradiert werden.
(c) Es erfolgt nur eine Messung von Text, da die Temperatur im Verlauf 63 zwischen allen Degradationsschwellen und Sicherheitsgrenzen liegt, was gleichbedeutend ist mit einem normalen Betrieb und dem häufigsten Betriebspunkt für Mission Profile.
(d) Die Degradationsschwelle für Text ist überschritten, es erfolgt ein Wechsel zu TEIS, daher ist keine Degradation notwendig.
(e) Es liegt eine Überschreitung der Degradationsschwelle von TEIS vor, daher ist eine Degradation des Stroms notwendig.
(f) Es liegt eine Überschreitung der Sicherheitsgrenze für Text vor, da eine Verwendung von TEIS Betrieb immer noch möglich ist.
(g) Die Sicherheitsgrenze von Text wird wieder eingehalten, es erfolgt eine Verwendung von TEIS, daher wird weiter eine Stromdegradation durchgeführt.
(h) Die Degradationsgrenze von TEIS wird wieder eingehalten, es ist keine Stromdegradation notwendig; bei einer Verwendung von Text wäre die Leistung eingeschränkt.
(i) Alle Degradationsgrenzen werden eingehalten, die Messung erfolgt wieder über Text.
(j) Degradationsgrenze für Text wird wieder erreicht, es erfolgt eine Umschaltung auf TEIS, dadurch ist keine Degradation notwendig.

Im vorangegangenen Beispiel wird im Zusammenhang mit Figur 3 von einer kontinuierlichen Messung - z.B. mit einer Messfrequenz von 1 Hz - des jeweiligen Sensors 20, 21 und/oder des Bestimmungsverfahrens ausgegangen.

Auch in den Phasen, in welchen nur eine Messung über Text notwendig wäre, z.B. bei den Phasen(c), (i), (k), kann in kurzen Intervallen die Temperaturmessung über TEIS gestützt werden.

Dies könnte zum Beispiel so aussehen:
- Es erfolgt eine kontinuierliche Messung von Text in den Phasen (c), (i), und (k) mit einer Stützung durch TEIS alle 5 Minuten.
- Durch einen Wert aus TEIS erfolgt eine Korrektur des Temperaturmodells, denkbar sind auch Varianten des Kalmanfilters.

### Bezugszeichenliste:

- 1: Vorrichtung, Messvorrichtung, Messanordnung

- 10: Batteriezelle
- 20: Sensor
- 21: Temperatursensor
- 30: Temperaturmesseinrichtung
- 31: Erfassungs- und Steuerleitung
- 40: Impedanzmesseinrichtung
- 41: (erste) Erfassungs- und Steuerleitung
- 42: (zweite) Erfassungs- und Steuerleitung

- 50: Graph
- 51: Abszisse
- 52: Ordinate
- 53: Spur, Temperatur
- 53-1: überschreitender/maximaler Wert der Spur 53
- 55: (erster) sicherer Bereich
- 55-1: Untergrenze
- 55-2: Obergrenze
- 57: (zweiter) kritischer Bereich
- 57-1: Untergrenze
- 57-2: Obergrenze

- 60: Graph
- 61: Abszisse
- 62: Ordinate
- 63: Spur, Temperatur

- 71: untere Degradationsschwelle für Temperatur aus Impedanz
- 72: untere Degradationsschwelle für Temperatur aus externem Sensor 20
- 73: obere Degradationsschwelle für Temperatur aus Impedanz
- 74: obere Degradationsschwelle für Temperatur aus externem Sensor 20
- 75: Sicherheitsschwelle für Temperatur aus Impedanz
- 76: Sicherheitsschwelle für Temperatur aus externem Sensor 20

- 100: Steuereinheit

## Patentansprüche

1. Verfahren zum Bestimmen einer Betriebstemperatur einer Batteriezelle (10), insbesondere bei einer elektrisch betreibbaren Arbeitsvorrichtung oder einem Fahrzeug, bei welchem
- eine externe Temperatur der Batteriezelle (10) - insbesondere kontinuierlich oder abschnittsweise kontinuierlich mit einem außerhalb der Batteriezelle (10) angeordneten Sensor (20) erfasst wird,
- eine interne Temperatur der Batteriezelle (10) über ein Erfassen einer elektrischen Impedanz der Batteriezelle (10) bestimmt wird und
- aus der externen und/oder der internen Temperatur ein Wert der Betriebstemperatur der Batteriezelle (10) bestimmt wird,
- wobei die interne Temperatur der Batteriezelle (10) zumindest in einem ersten Betriebszustand der Batteriezelle (10)
- weniger häufig bestimmt wird, wenn der Wert der ermittelten externen Temperatur, der internen und/oder der Betriebstemperatur der Batteriezelle (10) in einem vorgegebenen ersten sicheren Bereich (55) liegt, und
- häufiger bestimmt wird, wenn der Wert der ermittelten externen Temperatur, der internen Temperatur und/oder der Betriebstemperatur der Batteriezelle (10) außerhalb des vorgegebenen ersten sicheren Bereichs (55) liegt.

2. Verfahren nach Anspruch 1, bei welchem die interne Temperatur der Batteriezelle (10) weniger häufig bestimmt wird als die externe Temperatur der Batteriezelle (10), wenn der Wert der ermittelten externen Temperatur, der internen Temperatur und/oder der Betriebstemperatur der Batteriezelle (10) innerhalb des vorgegebenen ersten sicheren Bereichs (55) liegt.

3. Verfahren nach einem der vorangehenden Ansprüche, bei welchem die interne Temperatur der Batteriezelle (10) nicht oder nicht weiter bestimmt wird, wenn der Wert der ermittelten externen Temperatur, der internen Temperatur und/oder der Betriebstemperatur der Batteriezelle (10) innerhalb des vorgegebenen ersten sicheren Bereichs (55) liegt.

4. Verfahren nach einem der vorangehenden Ansprüche, bei welchem die externe Temperatur der Batteriezelle (10) unter Verwendung eines Temperatursensors (21) erfasst wird.

5. Verfahren nach einem der vorangehenden Ansprüche, bei welchem zum Bestimmen der externen Temperatur der Batteriezelle (10) ein vom Sensor (20) erfasster Wert einer Messgröße in einem Temperaturmodell für die Batteriezelle (10) verwendet wird.

6. Verfahren nach Anspruch 5, bei welchem zur Anpassung und/oder Stützung des Temperaturmodells gegebenenfalls ein oder mehrere über die elektrische Impedanz der Batteriezelle (10) erfasste Werte der internen Temperatur der Batteriezelle (10) verwendet werden.

7. Verfahren nach einem der vorangehenden Ansprüche, bei welchem
- der erste Betriebszustand der Batteriezelle (10) ein Ruhezustand der Batteriezelle (10), ein Lastzustand der Batteriezelle (10) oder ein Entladezustand der Batteriezelle (10) ist, bei welchem der Batteriezelle (10) Energie entnommen wird oder die Batteriezelle (10) Energie abgibt, und/oder
- der vorgegebene erste sichere Bereich (55) definiert ist durch eine Untergrenze (55-1) eines Werts für eine Temperatur und/oder durch eine Obergrenze (55-2) eines Werts für eine Temperatur, insbesondere im Bereich von etwa -10 °C bzw. +50 °C.

8. Verfahren nach einem der vorangehenden Ansprüche, bei welchem in einem zweiten Betriebszustand der Batteriezelle (10), der vom ersten Betriebszustand der Batteriezelle (10) verschieden ist und insbesondere einem Ladezustand der Batteriezelle (10) oder einem Rekuperation Zustand der Batteriezelle (10) entspricht, bei welchem der Batteriezelle (10) Energie zugeführt wird oder die Batteriezelle (10) Energie aufnimmt, die Häufigkeit des Bestimmens der internen Temperatur der Batteriezelle (10) unabhängig ist von der Lage der ermittelten externen Temperatur, der internen Temperatur und/oder der Betriebstemperatur der Batteriezelle (10) in Bezug auf den vorgegebenen ersten sicheren Bereich (55) und der insbesondere der Häufigkeit des Bestimmens der externen Temperatur der Batteriezelle (10) entspricht.

9. Betriebsverfahren für eine Batteriezelle (10), insbesondere bei einer elektrisch betreibbaren Arbeitsvorrichtung oder einem Fahrzeug, bei welchem eine Betriebstemperatur der Batteriezelle (10) durch ein Verfahren nach einem der Ansprüche 1 bis 8 bestimmt und zur Steuerung des Betriebs der Batteriezelle (10) verwendet wird.

10. Betriebsverfahren für eine Batteriezelle (10) nach Anspruch 9, bei welchem
- geprüft wird, ob der Wert der externen Temperatur der Batteriezelle (10), der Wert der internen Temperatur der Batteriezelle (10) und/oder der Wert der abgeleiteten Betriebstemperatur der Batteriezelle (10) außerhalb eines vorgegebenen zweiten kritischen Bereichs (57) liegt bzw. liegen, welcher den vorgegebenen kritischen Bereich (50) als ersten kritischen Bereich umfasst, und
- in Abhängigkeit von einem Ergebnis dieses Prüfens ein Betriebszustand der Batteriezelle (10) gewählt und/oder beeinflusst wird.

11. Steuereinheit (100) für eine Batteriezelle (10) und/oder für eine Arbeitsvorrichtung oder ein Fahrzeug mit einer Batteriezelle (10), welche eingerichtet ist, ein Verfahren nach einem der Ansprüche 1 bis 8 und/oder ein Betriebsverfahren nach Anspruch 9 oder 10 auszuführen.

12. Vorrichtung (1) zum Bestimmen einer Betriebstemperatur einer Batteriezelle (10), insbesondere bei einer elektrisch betreibbaren Arbeitsvorrichtung oder einem Fahrzeug, mit
- einer Impedanzmesseinrichtung (40), welche zur Messung einer elektrischen Impedanz der Batteriezelle (10) eingerichtet ist,
- einer Temperaturmesseinrichtung (30), welche zur Messung einer externen Temperatur der Batteriezelle (10) oder eines dafür repräsentativen Messwerts eingerichtet ist und dazu insbesondere einen in Bezug auf die Batteriezelle (10) außerhalb angeordneten Sensor (20, 21) oder eine Wirkverbindung zu einem in Bezug auf die Batteriezelle (10) außerhalb angeordneten Sensor (20, 21) aufweist, und
- einer Steuereinheit nach Anspruch 11, welche zur Erfassung von Messwerten der Impedanzmesseinrichtung (40) und der Temperaturmesseinrichtung (30) eingerichtet ist.

13. Arbeitsvorrichtung und insbesondere Fahrzeug, mit
- einem elektrisch antreibbaren Aggregat, insbesondere einem Antrieb,
- einer Batteriezelle (10) zur steuerbaren Versorgung des Aggregats mit elektrischer Energie und
- einer Steuervorrichtung zur Steuerung des Betriebs des Aggregats und/oder der Batteriezelle (10), welche ausgebildet ist mit einer Steuereinheit (100) nach Anspruch 11 und/oder mit einer Vorrichtung (1) nach Anspruch 12 und/oder dazu, ein Verfahren nach einem der Ansprüche 1 bis 8 und/oder ein Betriebsverfahren nach Anspruch 9 oder 10 auszuführen.

## Claims

1. Method for determining an operating temperature of a battery cell (10), in particular in an electrically operable working device or a vehicle, in which
- an external temperature of the battery cell (10) is detected, in particular continuously or partially continuously, using a sensor (20) arranged outside the battery cell (10),
- an internal temperature of the battery cell (10) is determined by detecting an electrical impedance of the battery cell (10), and
- a value of the operating temperature of the battery cell (10) is determined from the external temperature and/or from the internal temperature,
- wherein at least in a first operating state of the battery cell (10) the internal temperature of the battery cell (10)
- is determined less frequently if the value of the ascertained external temperature, of the internal temperature and/or of the operating temperature of the battery cell (10) is in a predefined first safe range (55), and
- is determined more frequently if the value of the ascertained external temperature, of the internal temperature and/or of the operating temperature of the battery cell (10) is outside the predefined first safe range (55).

2. Method according to Claim 1, in which the internal temperature of the battery cell (10) is determined less frequently than the external temperature of the battery cell (10) if the value of the ascertained external temperature, of the internal temperature and/or of the operating temperature of the battery cell (10) is within the predefined first safe range (55).

3. Method according to either of the preceding claims, in which the internal temperature of the battery cell (10) is not determined or does not continue to be determined if the value of the ascertained external temperature, of the internal temperature and/or of the operating temperature of the battery cell (10) is within the predefined first safe range (55).

4. Method according to one of the preceding claims, in which the external temperature of the battery cell (10) is detected using a temperature sensor (21).

5. Method according to one of the preceding claims, in which in order to determine the external temperature of the battery cell (10) a value, detected by the sensor (20), of a measured variable is used in a temperature model for the battery cell (10).

6. Method according to Claim 5, in which in order to adapt and/or support the temperature model, if appropriate one or more values of the internal temperature of the battery cell (10) which have been detected by means of the electrical impedance of the battery cell (10) are used.

7. Method according to one of the preceding claims, in which
- the first operating state of the battery cell (10) is a state of rest of the battery cell (10), a load state of the battery cell (10) or a discharge state of the battery cell (10), in which energy is extracted from the battery cell (10), or the battery cell (10) outputs energy, and/or
- the predefined first safe range (55) is defined by a lower limit (55-1) of a value for a temperature and/or by an upper limit (55-2) of a value for a temperature, in particular in the region of approximately -10°C or +50°C.

8. Method according to one of the preceding claims, in which, in a second operating state of the battery cell (10), which is different from the first operating state of the battery cell (10), and, in particular, corresponds to a state of charge of the battery cell (10) or a recuperation state of the battery cell (10), in which energy is fed to the battery cell (10) or the battery cell (10) takes up energy, the frequency of determination of the internal temperature of the battery cell (10) is independent of the status of the ascertained external temperature, of the internal temperature and/or of the operating temperature of the battery cell (10) with respect to the predefined first safe range (55), and which corresponds, in particular, to the frequency of determination of the external temperature of the battery cell (10).

9. Operating method for a battery cell (10), in particular in an electrically operable working device or a vehicle, in which an operating temperature of the battery cell (10) is determined by means of a method according to one of Claims 1 to 8, and is used to control the operation of the battery cell (10).

10. Operating method for a battery cell (10) according to Claim 9, in which
- it is tested whether the value of the external temperature of the battery cell (10), the value of the internal temperature of the battery cell (10) and/or the value of the derived operating temperature of the battery cell (10) are/is outside a predefined second critical range (57) which comprises the predefined critical range (50) as a first critical range, and
- an operating state of the battery cell (10) is selected and/or influenced as a function of a result of this testing.

11. Control unit (100) for a battery cell (10) and/or for a working device or a vehicle having a battery cell (10), which is configured to carry out a method according to one of Claims 1 to 8 and/or an operating method according to Claim 9 or 10.

12. Device (1) for determining an operating temperature of a battery cell (10), in particular in an electrically operable working device or a vehicle, having
- an impedance measuring apparatus (40) which is configured to measure an electrical impedance of the battery cell (10),
- a temperature measuring apparatus (30) which is configured to measure an external temperature of the battery cell (10) or a measured value which is representative thereof, and has, for this purpose, in particular a sensor (20, 21) which is arranged outside the battery cell (10) or an operative connection to a sensor (20, 21) which is arranged outside the battery cell (10), and
- a control unit according to Claim 11, which is configured to detect measured values of the impedance measuring apparatus (40) and of the temperature measurement apparatus (30).

13. Working device, and in particular vehicle, having
- an electrically drivable assembly, in particular a drive,
- a battery cell (10) for supplying the assembly with electrical energy in a controllable fashion, and
- a control device for controlling the operation of the assembly and/or of the battery cell (10) which is embodied with a control unit (100) according to Claim 11 and/or with a device (1) according to Claim 12 and/or is designed to carry out a method according to one of Claims 1 to 8 and/or an operating method according to Claim 9 or 10.

## Revendications

1. Procédé permettant de déterminer une température de fonctionnement d'un élément de batterie (10), en particulier sur un dispositif de travail ou un véhicule à fonctionnement électrique, dans lequel
- une température externe de l'élément de batterie (10) est détectée, en particulier en continu ou par moments en continu, par un capteur (20) disposé à l'extérieur de l'élément de batterie (10),
- une température interne de l'élément de batterie (10) est déterminée par une détection d'une impédance électrique de l'élément de batterie (10), et
- une valeur de la température de fonctionnement de l'élément de batterie (10) est déterminée à partir de la température externe et/ou interne,
- dans lequel, au moins dans un premier état de fonctionnement de l'élément de batterie (10), la température interne de l'élément de batterie (10)
- est déterminée moins souvent si la valeur de la température externe établie, de la température interne et/ou de la température de fonctionnement de l'élément de batterie (10) se trouve dans une première plage sûre prédéfinie (55), et
- est déterminée plus souvent si la valeur de la température externe établie, de la température interne et/ou de la température de fonctionnement de l'élément de batterie (10) se trouve en dehors de la première plage sûre prédéfinie (55).

2. Procédé selon la revendication 1, dans lequel la température interne de l'élément de batterie (10) est déterminée moins souvent que la température externe de l'élément de batterie (10) si la valeur de la température externe, de la température interne et/ou de la température de fonctionnement établie(s) de l'élément de batterie (10) se trouve dans la première plage sûre prédéfinie (55).

3. Procédé selon l'une quelconque des revendications précédentes, dans lequel la température interne de l'élément de batterie (10) n'est pas ou n'est plus déterminée si la valeur de la température externe, de la température interne et/ou de la température de fonctionnement établie(s) de l'élément de batterie (10) se trouve dans la première plage sûre prédéfinie (55).

4. Procédé selon l'une quelconque des revendications précédentes, dans lequel la température externe de l'élément de batterie (10) est détectée en utilisant un capteur de température (21).

5. Procédé selon l'une quelconque des revendications précédentes, dans lequel, pour la détermination de la température externe de l'élément de batterie (10), une valeur d'une grandeur de mesure, détectée par le capteur (20), est utilisée dans un modèle de température pour l'élément de batterie (10).

6. Procédé selon la revendication 5, dans lequel le cas échéant, une ou plusieurs valeurs de la température interne de l'élément de batterie (10), détectées par l'intermédiaire de l'impédance électrique de l'élément de batterie (10), sont utilisées pour adapter et/ou assister le modèle de température.

7. Procédé selon l'une quelconque des revendications précédentes, dans lequel
- le premier état de fonctionnement de l'élément de batterie (10) est un état de repos de l'élément de batterie (10), un état de charge de l'élément de batterie (10) ou un état de déchargement de l'élément de batterie (10) dans lequel de l'énergie est prélevée de l'élément de batterie (10) ou l'élément de batterie (10) fournit de l'énergie, et/ou
- la première plage sûre prédéfinie (55) est définie par une limite inférieure (55-1) d'une valeur pour une température et/ou par une limite supérieure (55-2) d'une valeur pour une température, en particulier dans la plage d'environ -10 °C ou +50 °C.

8. Procédé selon l'une quelconque des revendications précédentes, dans lequel, dans un deuxième état de fonctionnement de l'élément de batterie (10) qui est différent du premier état de fonctionnement de l'élément de batterie (10) et correspond en particulier dans un état de charge de l'élément de batterie (10) ou à un état de récupération de l'élément de batterie (10) dans lequel de l'énergie est fournie à l'élément de batterie (10) ou l'élément de batterie (10) absorbe de l'énergie, la fréquence de la détermination de la température interne de l'élément de batterie (10) dépend de la position de la température externe, de la température interne et/ou de la température de fonctionnement établie(s) de l'élément de batterie (10) par rapport à la première plage sûre prédéfinie (55) et qui correspond en particulier à la fréquence de la détermination de la température externe de l'élément de batterie (10).

9. Procédé de fonctionnement pour un élément de batterie (10), en particulier sur un dispositif de travail ou un véhicule à fonctionnement électrique, dans lequel une température de fonctionnement de l'élément de batterie (10) est déterminée par un procédé selon l'une quelconque des revendications 1 à 8 et est utilisée pour commander le fonctionnement de l'élément de batterie (10).

10. Procédé de fonctionnement pour un élément de batterie (10) selon la revendication 9, dans lequel
- il est vérifié si la valeur de la température externe de l'élément de batterie (10), la valeur de la température interne de l'élément de batterie (10) et/ou la valeur de la température de fonctionnement de l'élément de batterie (10) dérivée se trouve(nt) en dehors d'une deuxième plage critique prédéfinie (57) qui comprend la plage critique prédéfinie (50) comme première plage critique, et
- un état de fonctionnement de l'élément de batterie (10) est sélectionné et/ou influencé en fonction d'un résultat de cette vérification.

11. Unité de commande (100) pour un élément de batterie (10) et/ou pour un dispositif de travail ou un véhicule comprenant un élément de batterie (10), qui est conçue pour exécuter un procédé selon l'une quelconque des revendications 1 à 8 et/ou un procédé de fonctionnement selon la revendication 9 ou 10.

12. Dispositif (1) permettant de déterminer une température de fonctionnement d'un élément de batterie (10), en particulier sur un dispositif de travail ou un véhicule à fonctionnement électrique, comprenant
- un dispositif de mesure d'impédance (40) qui est conçu pour mesurer une impédance électrique de l'élément de batterie (10),
- un dispositif de mesure de température (30) qui est conçu pour mesurer une température externe de l'élément de batterie (10) ou une valeur de mesure représentative de celle-ci et présente à cet effet en particulier un capteur (20, 21) disposé à l'extérieur par rapport à l'élément de batterie (10) ou une relation active avec un capteur (20, 21) disposé à l'extérieur par rapport à l'élément de batterie (10), et
- une unité de commande selon la revendication 11 qui est conçue pour détecter des valeurs de mesure du dispositif de mesure d'impédance (40) et du dispositif de mesure de température (30).

13. Dispositif de travail, et en particulier véhicule, comprenant
- un groupe à fonctionnement électrique, en particulier un entraînement,
- un élément de batterie (10) servant à l'alimentation réglable du groupe en énergie électrique, et
- un dispositif de commande servant à commander le fonctionnement du groupe et/ou de l'élément de batterie (10), qui est réalisé avec une unité de commande (100) selon la revendication 11 et/ou un dispositif (1) selon la revendication 12, et/ou pour exécuter un procédé selon l'une quelconque des revendications 1 à 8 et/ou un procédé de fonctionnement selon la revendication 9 ou 10.
